(19) **Europäisches Patentamt**

**European Patent Office**

**Office européen des brevets**

(11) **EP 1 428 309 B1**

(12) **FASCICULE DE BREVET EUROPEEN**

(45) Date de publication et mention
de la délivrance du brevet:
**06.12.2006 Bulletin 2006/49**

(51) Int Cl.:
*H02M 3/335* (2006.01)      *G01R 19/20* (2006.01)
*G01R 15/18* (2006.01)

(21) Numéro de dépôt: **02779641.6**

(22) Date de dépôt: **19.09.2002**

(86) Numéro de dépôt international:
**PCT/FR2002/003211**

(87) Numéro de publication internationale:
**WO 2003/028198 (03.04.2003 Gazette 2003/14)**

(54) **DISPOSITIF DE MESURE D'UN COURANT HACHE**

ANORDNUNG ZUM MESSEN EINES STROMZERHACKERS

DEVICE FOR MEASURING A CHOPPED CURRENT

(84) Etats contractants désignés:
**DE ES GB IT PT SE**

(30) Priorité: **21.09.2001 FR 0112220**

(43) Date de publication de la demande:
**16.06.2004 Bulletin 2004/25**

(73) Titulaire: **Valeo Electronique et Systemes de
Liaison
78180 Montigny le Bretonneux (FR)**

(72) Inventeur: **SARDAT, Pierre
F-93340 LE RAINCY (FR)**

(74) Mandataire: **de la Bigne, Guillaume Michel Marie
Lhermet La Bigne & Rémy
11, boulevard de Sébastopol
75001 Paris (FR)**

(56) Documents cités:
**DE-A- 3 727 170          US-A- 5 068 776
US-A- 5 923 548**

## Description

La présente invention concerne un dispositif de mesure d'un courant haché du type comportant un transformateur d'impulsions.

Le transformateur comporte un circuit primaire dans lequel circule le courant haché et un circuit secondaire dans lequel circule un courant de sortie proportionnel au courant haché, le circuit secondaire du transformateur comprenant deux bornes de sortie entre lesquelles est connecté un circuit de mesure du courant de sortie. Par ailleurs, le dispositif de mesure comporte des moyens de démagnétisation du transformateur.

En première approximation, on peut modéliser les imperfections du transformateur d'impulsions par une inductance parasite disposée entre les bornes de sortie du circuit secondaire. Ainsi, une portion négligeable du courant de sortie circule dans cette inductance parasite. Mais cette portion de courant négligeable, appelée « courant magnétisant » augmente compte tenu de la différence de potentiel maintenue aux bornes de l'inductance parasite. Ce phénomène, appelé phénomène de magnétisation, apparaît dès lors que l'on effectue la mesure du courant de sortie dans le circuit de mesure.

Par conséquent, il est nécessaire de démagnétiser régulièrement le transformateur d'impulsions en faisant par exemple circuler le courant magnétisant à travers un circuit de démagnétisation.

Généralement, lorsqu'un tel dispositif de mesure est appliqué à la mesure d'un courant haché circulant à l'intérieur d'un convertisseur de courant continu en courant continu, le circuit de mesure est constitué d'une résistance montée en série avec une première diode.

Le circuit de démagnétisation est, quant à lui, généralement constitué d'une diode Zener montée en série avec une seconde diode disposée en sens inverse de la diode Zener, pour empêcher toute circulation de courant dans le circuit de démagnétisation lorsqu'un courant circule dans le circuit de mesure dans le sens autorisé par la première diode, et inversement pour permettre à un courant de circuler dans le circuit de démagnétisation lorsque la première diode l'empêche de circuler dans le circuit de mesure.

Ainsi, ce dispositif permet de mesurer un courant haché monodirectionnel circulant dans le circuit primaire du transformateur. En effet, dans l'un uniquement des deux sens possibles de circulation du courant dans le circuit primaire du transformateur, le courant de sortie induit dans le circuit secondaire est autorisé à circuler dans le circuit de mesure, dans le sens passant de la première diode. Ce courant de sortie est proportionnel au courant d'entrée puisque le courant magnétisant peut être considéré comme négligeable. Par contre, il ne peut circuler dans le circuit de démagnétisation, ni dans un premier sens parce qu'il en est empêché par la seconde diode, ni dans l'autre sens parce qu'il en est empêché par une différence de potentiel positive.

Ainsi, le courant de sortie circule intégralement dans le circuit de mesure et le courant d'entrée peut être déduit de la mesure de la tension de sortie $V_s$ aux bornes de la résistance de sortie $R_s$, par la formule suivante :

$$i_e = \frac{V_s}{R_s} \times \frac{N_s}{N_p}$$

où $N_s$ est le nombre de spires dans le circuit secondaire du transformateur d'impulsions et $N_p$ est le nombre de spires dans le circuit primaire de ce même transformateur.

L'opération de démagnétisation est effectuée lorsque le courant d'entrée induit un courant de sortie nul, ou non autorisé à circuler dans le circuit de mesure, parce qu'il en est empêché par la première diode. Le courant magnétisant peut donc circuler librement et uniquement dans le circuit de démagnétisation et l'énergie accumulée dans l'inductance parasite peut être ainsi libérée.

L'inconvénient majeur de ce dispositif est son caractère monodirectionnel. En effet, on ne peut mesurer le courant haché que dans un seul sens.

Or il arrive que l'on ait besoin de mesurer un courant haché à valeur moyenne nulle, par exemple pour mesurer le courant haché circulant dans un convertisseur de courant continu en courant continu, reliant deux batteries d'alimentation de tensions différentes. Dans ce cas, le courant à mesurer comporte nécessairement des valeurs positives et négatives.

L'invention vise à remédier aux inconvénients d'un dispositif de mesure classique, en créant un dispositif de mesure d'un courant haché, capable de mesurer toutes les valeurs non nulles de ce courant à chaque instant, même si celui-ci est bidirectionnel.

US-A-5 068 776 décrit un dispositif de mesure d'un courant haché comportant :

-    un transformateur d'impulsions comportant un circuit primaire dans lequel circule le courant haché, et un circuit secondaire, dans lequel circule un courant de sortie proportionnel au courant haché, ce circuit secondaire comprenant deux bornes de sortie entre lesquelles est connecté un circuit de mesure du courant de sortie, ce circuit de mesure comportant un interrupteur et des moyens de synchronisation de cet interrupteur avec le courant haché, et
-    des moyens de démagnétisation du transformateur comprenant un circuit de démagnétisation connecté entre les deux bornes de sortie du circuit secondaire.

US-A-5 923 548 décrit un dispositif de mesure de courant haché comprenant un circuit primaire dans lequel circule un courant haché et un circuit de mesure dans lequel circule un courant de sortie, proportionnel au courant haché, uniquement lorsque le courant haché est strictement positif.

L'invention a pour objet un dispositif de mesure de courant haché du type décrit dans US-A-5 068 776, caractérisé en ce que le circuit de démagnétisation est bidirectionnel et en ce que l'interrupteur est bidirectionnel à l'état ouvert et à l'état fermé, pour permettre au courant de sortie de circuler ans le circuit de mesure lorsque le courant haché est strictement positif et lorsqu'il est strictement négatif et pour empêcher toute circulation de courant dans le circuit de mesure lorsque le courant haché est nul.

Ainsi, un dispositif de mesure selon l'invention ne nécessite pas la présence de la première diode dans le circuit de mesure, puisque celle-ci est avantageusement remplacée par l'interrupteur et les moyens de synchronisation. Cet interrupteur permet la circulation du courant de sortie dans les deux sens dans le circuit de mesure tout en permettant la nécessaire démagnétisation du circuit secondaire du transformateur, lorsque le courant haché est nul.

Le dispositif de mesure selon l'invention peut en outre comporter l'une ou plusieurs des caractéristiques suivantes :

- l'interrupteur comporte au moins un transistor MOS à effet de champ ou un transistor à jonction bipolaire ;
- le circuit de démagnétisation comporte deux diodes Zener montées en série et en sens inverse;
- l'interrupteur comporte deux transistor MOS à effet de champ montés en série et en sens inverse dans le circuit de mesure.

L'invention sera mieux comprise à l'aide de la description qui va suivre, donnée uniquement à titre d'exemple et faite en se référant aux dessins annexés sur lesquels :

- la figure 1 représente l'allure temporelle de l'intensité d'un courant haché bidirectionnel pouvant être mesuré par un dispositif selon l'invention ;
- la figure 2 représente schématiquement un dispositif de mesure selon un premier mode de réalisation de l'invention; et
- la figure 3 représente schématiquement un dispositif de mesure selon un second mode de réalisation de l'invention.

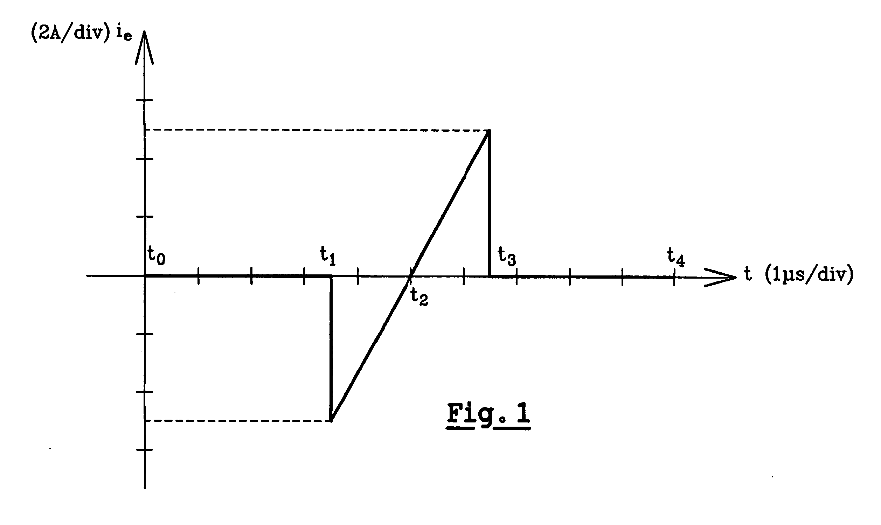

Le courant haché $i_e$ dont l'allure temporelle est représentée à la figure 1 est périodique, de période égale à 10 micro-secondes.

Sur une période, entre un instant $t_0 = 0$ $\mu$s et $t_1 = 3,5$ $\mu$s, le courant haché $i_e$ est nul.

A l'instant $t_1$, le courant haché prend instantanément la valeur $i_e = -5$ A. Ensuite, entre l'instant $t_1$ et un instant $t_2 = 5$ $\mu$s le courant haché croît quasi-linéairement de la valeur $i_e = -5$ A à la valeur $i_e = 0$ A. Entre $t_1$ et $t_2$, le courant haché est donc négatif.

Entre l'instant $t_2$ et un instant $t_3 = 6,5$ $\mu$s, le courant haché continue à croître quasi-linéairement de la valeur $i_e = 0$ A à $i_e = 5$ A. Entre $t_2$ et $t_3$, le courant haché est donc positif.

A l'instant le courant haché prend instantanément la valeur $i_e = 0$ A. Ensuite de l'instant $t_3$ à un instant $t_4 = 10$ $\mu$s, c'est à-dire la fin de la période, le courant haché $i_e$ est nul.

On souhaite mesurer le courant haché $i_e$ entre les instants $t_1$ et $t_3$, c'est-à-dire lorsqu'il croît quasi-linéairement d'une première valeur négative de -5 A à une seconde valeur positive de 5 A. Pendant cette phase de mesure, le transformateur d'impulsions est magnétisé. La démagnétisation du transformateur s'effectue donc dès l'instant $t_3$ et se prolonge tant que le courant haché est nul, c'est-à-dire jusqu'à un instant $t_4 + (t_1 - t_0)$.

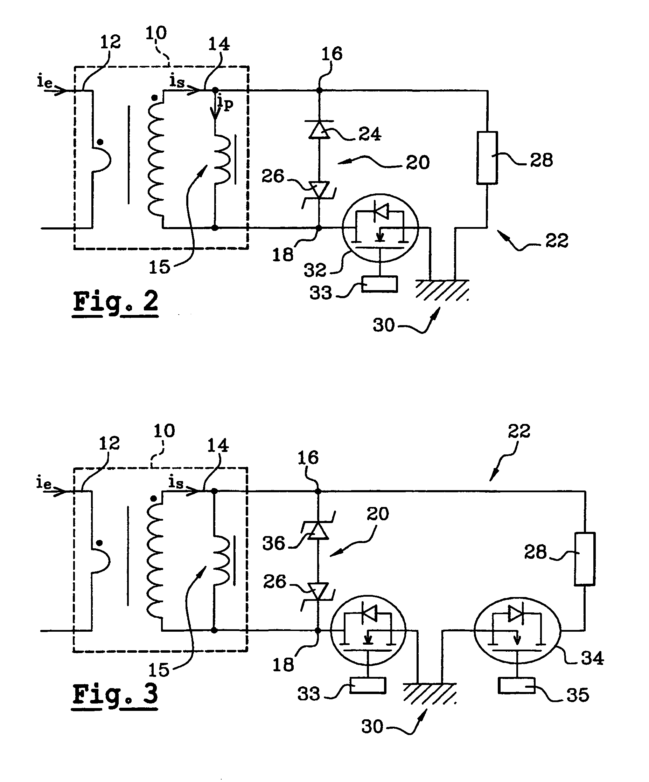

Un premier mode de réalisation d'un dispositif de mesure de ce courant haché $i_e$ est représenté à la figure 2.

Ce dispositif comporte un transformateur d'impulsions 10 comprenant un circuit primaire 12 à $N_p$ spires et un circuit secondaire 14 à $N_s$ spires.

Le circuit secondaire 14 du transformateur d'impulsions 10 comporte deux bornes de sortie 16 et 18. En première approximation, les imperfections du transformateur 10 peuvent être représentées par une inductance 15 disposée entre les bornes de sortie 16 et 18 et provoquant la circulation d'un courant $i_p$ de magnétisation du transformateur.

Un circuit de démagnétisation 20 et un circuit de mesure 22 sont branchés en parallèle entre les deux bornes 16 et 18.

Le circuit de démagnétisation 20 est constitué d'une diode 24 connectée en série avec une diode Zener 26 entre les bornes de sortie 16 et 18. La diode 24 est disposée dans un sens qui empêche tout courant de circuler dans le circuit de démagnétisation 20, de la borne de sortie 16 à la borne de sortie 18. La diode Zener 26 est montée en sens inverse.

Le circuit de mesure 22 comporte une résistance de sortie 28 connectée d'une part à la borne de sortie 16 et d'autre part à un point de référence 30 à tension constante formant masse.

Le circuit de mesure 22 comporte en outre un interrupteur 32, constitué d'un transistor MOS à effet de champ. Le drain de ce transistor 32 est connecté à la borne de sortie 18 et la source de ce transistor est connectée à la masse 30.

Le transistor 32 constitue un interrupteur qui n'est pas entièrement bidirectionnel. En effet, lorsqu'il est à l'état fermé, il est bidirectionnel et laisse passer le courant dans le circuit de mesure 22 dans les deux sens. Par contre, lorsqu'il est à l'état ouvert, il est monodirectionnel et n'empêche le courant de passer que dans un seul sens, du drain vers la source.

Il est en outre relié à des moyens de synchronisation 33 qui commandent son état ouvert ou fermé en fonction du courant haché. Lorsque le courant haché $i_e$ est constamment nul, c'est-à-dire entre $t_0$ et $t_1$ et entre $t_3$ et $t_4$, les moyens de synchronisation 33 commandent le transistor 32 pour qu'il soit à l'état ouvert. Entre les instants $t_1$ et $t_3$, lorsque le courant haché $i_e$ est quasi-linéairement croissant, les moyens de synchronisation 33 commandent le transistor 32 pour qu'il soit à l'état fermé.

Ainsi, entre les instants $t_1$ et $t_2$, le courant haché $i_e$ est négatif et induit un courant de sortie $i_s$ circulant dans le circuit secondaire 14 de la borne 16 à la borne 18. Le transistor 32 étant à l'état fermé entre $t_1$ et $t_2$, un courant peut librement circuler dans le circuit de mesure 22 de la borne 18 à la borne 16.

Par contre, aucun courant ne circule dans le circuit de démagnétisation 20 parce que la diode Zener 26 n'est pas passante, étant donné que la tension entre les bornes 18 et 16 est variable et n'est pas égale à sa tension de Zener.

Le courant de sortie $i_s$ circule donc dans le circuit de mesure 22. Ceci a pour effet de produire un courant magnétisant $i_p$ dans l'inductance parasite 15 entre les bornes 18 et 16. Mais ce courant magnétisant ip étant négligeable par rapport à $i_s$ par conception, on mesure entre la masse 30 et la borne 16 une tension de sortie $V_s$ négative, proportionnelle au courant haché $i_e$.

Entre les instants $t_2$ et $t_3$, le courant haché $i_e$ est positif et induit un courant de sortie $i_s$ circulant de la borne 18 à la borne 16 dans le circuit secondaire 14. Le transistor 32 étant toujours à l'état fermé, ce courant de sortie circule également dans le circuit de mesure 22 et la tension $V_s$ mesurée est toujours proportionnelle au courant haché $i_e$.

De même que précédemment, un courant magnétisant circule à travers l'inductance parasite 15, cette fois-ci de la borne 16 à la borne 18. Par contre, aucun courant ne circule dans le circuit de démagnétisation 20, parce qu'il est en empêché par la diode 24.

Dès l'instant $t_3$, plus aucun courant ne circule dans le circuit primaire 12 du transformateur 10 et le transistor 32 passe à l'état ouvert. Ainsi, il ne permet pas à un courant de circuler de la borne 18 à la borne 16 dans le circuit de mesure 22.

Pourtant, à cet instant, le courant magnétisant ip circulant à travers l'inductance parasite 15 circule de la borne 16 à la borne 18. Ce courant ip ne peut donc circuler que dans le circuit de démagnétisation 20, la différence de potentiel entre les bornes 18 et 16 étant alors imposée par la tension Zener de la diode Zener 26. De la sorte, de l'instant $t_3$ à l'instant $t_4 + (t_1 - t_0)$, c'est-à-dire tant que le courant haché $i_e$ est nul, le courant magnétisant $i_p$ décroît en circulant dans le circuit de démagnétisation 20.

Pour que ce circuit de mesure fonctionne correctement, il est nécessaire que le courant haché $i_e$ soit positif lors de l'instant de démarrage $t_3$ de la démagnétisation du transformateur d'impulsions 10, afin que le courant magnétisant $i_p$ soit lui aussi positif. En effet, si à l'instant $t_3$, le courant haché $i_e$ était négatif, le courant magnétisant $i_p$ circulerait de la borne 18 à la borne 16 dans l'inductance parasite 15 et circulerait dans le circuit de mesure 22 au lieu de circuler à travers le circuit de démagnétisation 20, étant donné que le transistor 32 n'est pas bidirectionnel lorsqu'il est à l'état ouvert. En effet, dans ce sens, il se comporte comme un interrupteur fermé en raison de la présence de sa diode parasite.

Le second mode de réalisation d'un dispositif de mesure représenté à la figure 3 diffère du premier mode de réalisation décrit précédemment dans la constitution du circuit de mesure 22 et du circuit de démagnétisation 20.

Comme précédemment, le circuit de mesure 22 comporte le transistor 32 connecté entre la borne de sortie 18 et la masse 30. Par contre, la résistance de sortie 28 est connectée d'une part à la borne de sortie 16 et d'autre part au drain d'un autre transistor MOS à effet de champ 34, la source de cet autre transistor 34 étant connectée à la masse 30.

De même que le transistor 32, cet autre transistor 34 est commandé par un dispositif de synchronisation 35 identique au dispositif de synchronisation 33. Ainsi, lorsque le courant haché $i_e$ est non nul les deux transistors MOS 32 et 34 sont à l'état fermé et lorsque le courant haché $i_e$ est nul, ils sont à l'état ouvert.

L'ensemble constitué par ces deux transistors 32 et 34 disposés en sens inverse constitue un interrupteur complètement bidirectionnel à l'état ouvert et à l'état fermé.

En outre, dans le circuit de démagnétisation 20, la diode 24 est remplacée par une seconde diode Zener 36 disposée en sens inverse de la diode Zener 26. Ainsi, le circuit de démagnétisation 20 est lui aussi complètement bidirectionnel, c'est-à-dire qu'il permet une démagnétisation dans les deux sens de circulation du courant.

De la sorte, quel que soit le sens du courant magnétisant à travers l'inductance parasite 15 à l'instant $t_3$, lorsque le courant haché $i_e$ prend la valeur nulle, ce dispositif permet la démagnétisation du transformateur d'impulsions 10 dans le circuit de démagnétisation 20.

Il apparaît clairement qu'un dispositif de mesure de courant haché selon l'invention permet de mesurer un courant bidirectionnel quelconque $i_e$, c'est-à-dire quels que soient la forme et le sens du courant $i_e$, tout en restant simple dans sa conception.

## Revendications

1. Dispositif de mesure d'un courant haché ($i_e$) comportant :

   - un transformateur d'impulsions (10) comportant un circuit primaire (12) dans lequel circule le courant haché, et un circuit secondaire (14), dans lequel circule un courant de sortie ($i_s$) proportionnel au courant haché, ce circuit secondaire (14) comprenant deux bornes de sortie (16, 18) entre lesquelles est connecté un circuit (22) de mesure du courant de sortie, ce circuit de mesure comportant un interrupteur (32, 34) et des moyens (33, 35) de synchronisation de cet interrupteur avec le courant haché ($i_e$), et
- des moyens (20) de démagnétisation du transformateur comprenant un circuit de démagnétisation (20) connecté entre les deux bornes de sortie (16, 18) du circuit secondaire (14),

**caractérisé en ce que** le circuit de démagnétisation est bidirectionnel et **en ce que** l'interrupteur (32, 34) est bidirectionnel à l'état ouvert et à l'état fermé, pour permettre au courant de sortie ($i_s$) de circuler dans le circuit de mesure (22) lorsque le courant haché (ie) est strictement positif et lorsqu'il est strictement négatif et pour empêcher toute circulation de courant dans le circuit de mesure (22) lorsque le courant haché (ie) est nul.

2. Dispositif de mesure selon la revendication 1, **caractérisé en ce que** l'interrupteur (32) comporte au moins un transistor MOS à effet de champ ou un transistor à jonction bipolaire.

3. Dispositif de mesure selon la revendication 1 ou 2, **caractérisé en ce que** le circuit de démagnétisation (20) comporte deux diodes Zener montées en série et en sens inverse.

4. Dispositif de mesure selon l'une quelconque des revendications 1 à 3, **caractérisé en ce que** l'interrupteur (32, 34) comporte deux transistors MOS à effet de champ montés en série et en sens inverse dans le circuit de mesure (22).

## Claims

1. A device for measuring a chopped current ($i_e$), the device comprising firstly :

   - a pulse transformer (10), the transformer comprising a primary circuit (12) in which the chopped current flows and a secondary circuit (14) in which there flows an output current ($i_s$) proportional to the chopped current, the secondary circuit (14) having two output terminals (16, 18) between which there is connected an output current measuring circuit (22), the measuring circuit comprises a switch (32, 34) and means (33, 35) for synchronizing the switch with the chopped current ($i_e$), and also
   - means (20) for demagnetizing the transformer, comprising a demagnetizing circuit (20) connected between the two output terminals (16, 18) of the secondary circuit (14),

   the device being **characterized in that** the demagnetizing circuit (20) is bi-directional, and **in that** the switch (32, 34) is bi-directional in the OFF state and in the ON state, so as to enable the output current ($i_s$) to flow through the measuring circuit (22) whenever the chopped current ($i_e$) is strictly positive and whenever it is strictly negative, and to prevent any flow of current through the measuring circuit (22) whenever the chopped current ($i_e$) is zero.

2. A measuring device according to claim 1, **characterized in that** the switch (32) is a MOSFET or a bipolar junction transistor.

3. A measuring device according to claim 1 or 2, **characterized in that** the demagnetizing circuit (20) comprises two zener diodes connected in series and in opposite directions.

4. A measuring device according to any one of the claims 1 to 3, **characterized in that** the switch (32, 34) comprises two MOSFETs connected in series and in opposite directions in the measuring circuit (22).

## Patentansprüche

1. Vorrichtung zum Messen eines zerhackten Stroms ($i_e$), umfassend:

   - einen Impulstransformator (10), der eine Primärschaltung (12) aufweist, in welcher der zerhackte Strom fließt, und eine Sekundärschaltung (14), in welcher ein Ausgangsstrom ($i_s$) fließt, der proportional zum zerhackten Strom ist, wobei diese Sekundärschaltung (14) zwei Ausgangsklemmen (16, 18) aufweist, zwischen denen eine Schaltung (22) zum Messen des Ausgangsstroms angeschlossen ist, wobei diese Messschaltung einen Unterbrecher (32, 34) und Einrichtungen (33, 35) zur Synchronisation dieses Unterbrechers mit dem zerhackten Strom ($i_e$) umfasst, und
   - eine Einrichtung (20) zur Entmagnetisierung des Transformators, umfassend eine Entmagnetisierungsschaltung (20), die zwischen den beiden Ausgangsklemmen (16, 18) der Sekundärschaltung (14) angeschlossen ist,

   **dadurch gekennzeichnet, dass** die Entmagnetisierungsschaltung bidirektional ist und dass der Unterbrecher (32, 34) im offenen Zustand und im geschlossenen Zustand bidirektional ist, um dem Ausgangsstrom ($i_s$) zu ermöglichen, in der Messschaltung (22) zu fließen, wenn der zerhackte Strom ($i_e$) streng positiv ist und wenn er streng negativ ist, und um jedes Fließen von Strom in der Messschaltung (22) zu verhindern, wenn der zerhackte Strom ($i_e$) null ist.

**2.** Vorrichtung zum Messen nach Anspruch 1, **dadurch gekennzeichnet, dass** der Unterbrecher (32) mindestens einen Feldeffekttransistor mit Metall-Oxid-Halbleiter-Aufbau oder einen Bipolartransistor aufweist.

**3.** Vorrichtung zum Messen nach Anspruch 1 oder 2, **dadurch gekennzeichnet, dass** die Entmagnetisierungsschaltung (20) zwei Zenerdioden aufweist, die seriell und in entgegengesetzter Richtung montiert sind.

**4.** Vorrichtung zum Messen nach einem der Ansprüche 1 bis 3, **dadurch gekennzeichnet, dass** der Unterbrecher (32, 34) zwei Feldeffekttransistoren mit Metall-Oxid-Halbleiter-Aufbau aufweist, die seriell und in entgegengesetzter Richtung in der Messschaltung (22) montiert sind.

**(2A/div) $i_e$**

$t_0$     $t_1$     $t_3$     $t_4$

$t_2$

**t (1µs/div)**

<u>**Fig. 1**</u>

EP 1 428 309 B1

EP 1 428 309 B1

**Fig. 2**

**Fig. 3**

8